Europäisches Patentamt

European Patent Office

Office européen des brevets

(11) Publication number: **0 263 866 B1**

# EUROPEAN PATENT SPECIFICATION

(45) Date of publication of patent specification: **03.06.92**    (51) Int. Cl.5: **H01L 21/20**

(21) Application number: **87902923.9**

(22) Date of filing: **19.03.87**

(86) International application number:
**PCT/US87/00612**

(87) International publication number:
**WO 87/06392 (22.10.87 87/23)**

(54) SEMICONDUCTOR DEVICE INCLUDING AN EPITAXIAL LAYER ON A LATTICE-MISMATCHED SINGLE CRYSTAL SUBSTRATE.

(30) Priority: **10.04.86 US 850483**

(43) Date of publication of application:
**20.04.88 Bulletin 88/16**

(45) Publication of the grant of the patent:
**03.06.92 Bulletin 92/23**

(84) Designated Contracting States:
**DE FR GB IT NL**

(56) References cited:
**EP-A-00 026 58**

**Applied Physics Letters, volume 24, no.10, 15 May 1974, American Institute of Physics, (New York, US), M.Nakamura et al.:"Liquid phase epitaxy of GaAlAs on GaAs substrates with fine surface corrugations", pages 466-468**

(73) Proprietor: **AMERICAN TELEPHONE AND TELEGRAPH COMPANY**
**550 Madison Avenue**
**New York, NY 10022(US)**

(72) Inventor: **LURYI, Sergey**
**1591 Long Hill Road**
**Millington, NJ 07946(US)**

(74) Representative: **Watts, Christopher Malcolm Kelway, Dr. et al**
**AT&T (UK) LTD. AT&T Intellectual Property Division 5 Mornington Road**
**Woodford Green Essex IG8 OTU(GB)**

Rank Xerox (UK) Business Services

Applied Physics Letters, volume 48, no.3, 20 January 1986, American Institute of Physics , (New York, US), W.Katzschner et al.: "Reactive ion beam etching of InP with N2 and N2/ O2 mixtures", pages 230-232; see page 232; figure 5

Applied Physics Letters, volume 25, no. 1, 1 July 1974, American Institute of Physics, (New York, US), L.Yang et al.: "Epitaxial growth over optical gratings on GaAs", pages 67-68; see the whole document

Applied Physics Letters, volume 46, no. 1, 1 January 1985, American Institute of Physics, (New York, US), M.I.J.Beale et al.: "Microstructure and formation mechanism of porous silicon" , pages 86-88; see the whole document; cited in the application

Applied Physics Letters, volume 47, no. 8, 15 October 1985, (New York, US), H.Ishii et al.: "Selective Ge deposition on Si using thermal decomposition of GeH4", pages 863-865; see the whole document

Applied Physics Letters, volume 49, no. 12, 22 September 1986, American Institute of Physics, (New York, US), M.Schilling et al.: "Deformation-free overgrowth of reactive ion beam etched submicron structures in InP by liquid phase epitaxy", pages 710-712; see the whole document

## Description

### Background of the Invention

This invention relates to semiconductor devices including contiguous layers of lattice-mismatched materials.

In a variety of electronic circuit contexts, it is desirable to have available epitaxial layers or lattice-mismatched materials, each of the different materials being used to provide a device function which is best accomplished using that particular material. However, because of the lattice mismatch between different semiconductor materials--e.g., about 0.022nm (0.22 Angstrom) or about 4% mismatch between Ge and Si--during epitaxial growth, great stresses are unavoidably established in the region of the interface of epitaxial layer and substrate, whereby the epitaxial layer suffers in quality from such defects as lattice dislocations, so that transistors formed in the epitaxial layer do not operate properly, if at all. As the epitaxial layer is made thicker, the formation of lattice dislocation becomes more likely. For example, in order to grow upon a single crystal silicon substrate a dislocation-free epitaxial layer of $Ge_x Si_{l-x}$ having a thickness of even as little as 10nm (100 Angstrom), the Ge content must be limited to a mole fraction x less than about 0.5, whereas a mole fraction x equal to unity (pure Ge) is desirable for optical elements formed in the epitaxial layer, and in prior art such a layer (with x = l) cannot be grown dislocation-free upon a silicon substrate regardless of how small the thickness of the layer is made. More generally, it is desirable to extend the thickness range of dislocation-free heteroepitaxial layers grown upon single-crystal substrates, such as commercially available semiconductor substrates like Si, gallium arsenide (GaAs), and indium phosphide (InP). Hiromu Ishii and others, in Appl. Phys. Lett. 47 (8), pages 863-864, disclose the formation of an epitaxial layer of Ge on a Si substrate.

### Summary of the Invention

An arbitrarily thick, dislocation-free epitaxial layer of lattice-mismatched material, such as pure Ge, can be grown upon the surface of a single crystal Si substrate, as set out in claim 1. In this way, it is expected that the total strain energy (per unit area of the layer) stemming from the stresses due to the lattice mismatch of the epitaxial layer with respect to the substrate will not exceed the level at which dislocations would be generated, as explained in greater detail below. Hence, the quality of the epitaxial layer will be much improved; and thereby, dislocation-free lattice-mismatched heteroepitaxial layers can be grown to greater thicknesses. By "lattice-mismatched", it is meant that the substrate and epitaxial layer differ in their lattice constants by at least about 0.5% or 0.003 nm (0.03 Angstrom units).

### Brief Description of the Drawing

FIG. 1 is a top view diagram of a typical castellated surface region of a single crystal substrate;

FIG. 2 is a cross-section diagram of the typical castellated surface region shown in FIG. 1;

FIG. 3 is a cross-sectional diagram of an epitaxial layer grown upon the lattice-mismatched castellated surface shown in FIGS. 1 and 2, in accordance with the principles of the invention, with arrows indicating tangential stress in the epitaxial layer in cases where the horizontal lattice distance of the epitaxial layer is larger than that of the substrate;

FIG. 4 is a cross-sectional diagram showing an epitaxial layer of germanium grown upon a porous single crystal silicon substrate, in accordance with a specific embodiment of the inventions; and

FIG. 5 is a cross-section diagram of an integrated circuit including an epitaxial layer portion of lattice-mismatched semiconductor grown in accordance with this invention.

### Detailed Description

As previously noted, an epitaxial layer is grown, in accordance with this invention, upon a porous, castellated or otherwise submicron patterned surface. By "castellated" it is meant that the cross section of the substrate at the major surface is characterized by steep hills and valleys, the tops of the hills defining flat plateau surface portions that are mutually separated from one another by gaps formed by the valleys. In general, by a "submicron patterned" surface it is meant that the surface is characterized by flat plateaus of any arbitrary shape, each plateau having a maximum lateral extend of less than a micrometer, with gaps formed by grooves located between the plateaus, for example, as obtained by nanometer lithography described in a paper by K. Douglas et al, entitled "Nanometer Molecular Lithography", published in Applied Physics Letters, Vol. 48 (10), pages 676-678 (March 1986).

It should be noted that the plateau portions of the single crystal substrates all have the same crystallographic orientation. That is, because these plateaus all originate from the same single crystal substrate, their respective crystal structures have the same mutual orientations even after the original surface of the substrate has been made porous, castellated, or otherwise suitably patterned. Despite the lattice mismatch, it is expected that suitable patterning of the surface of the substrate will reduce sources of strain in the epitaxial layer so that the epitaxial layer is dislocation-free regardless of thickness, as explained in greater detail below. Such suitable patterning is characterized by plateaus and gaps whose lateral extents satisfy certain criteria. More specifically, the lateral extent of the gaps should be greater than about one-third the lateral extent of the plateaus in order to prevent formation of dislocations by superposition of strains arising from different plateaus; but the lateral extent of the gaps should not exceed approximately the lateral extent of the plateaus, in order to avoid undesirable dominance in the epitaxial layer of polycrystalline growth from areas of the substrate surface in the gaps. Moreover, the maximum lateral extent (2L) of the plateaus should not exceed a certain critical length ($2L_c$) which depends somewhat upon the desired epitaxial layer thickness: for an arbitrarily thick pure Ge layer grown on Si, this critical length ($2L_c$) is expected to be about 20nm (200 Angstrom). A similar value of the critical length is expected for growth of an arbitrarily thick gallium arsenide layer grown on Si.

It should be noted that a substrate of porous silicon--wherein gaps an plateaus both ordinarily have lateral extents of less than 10nm (100 Angstrom), typically about 3.5nm (35 Angstrom)--satisfies all these criteria for epitaxial growth of dislocation-free pure germanium of arbitrary thickness.

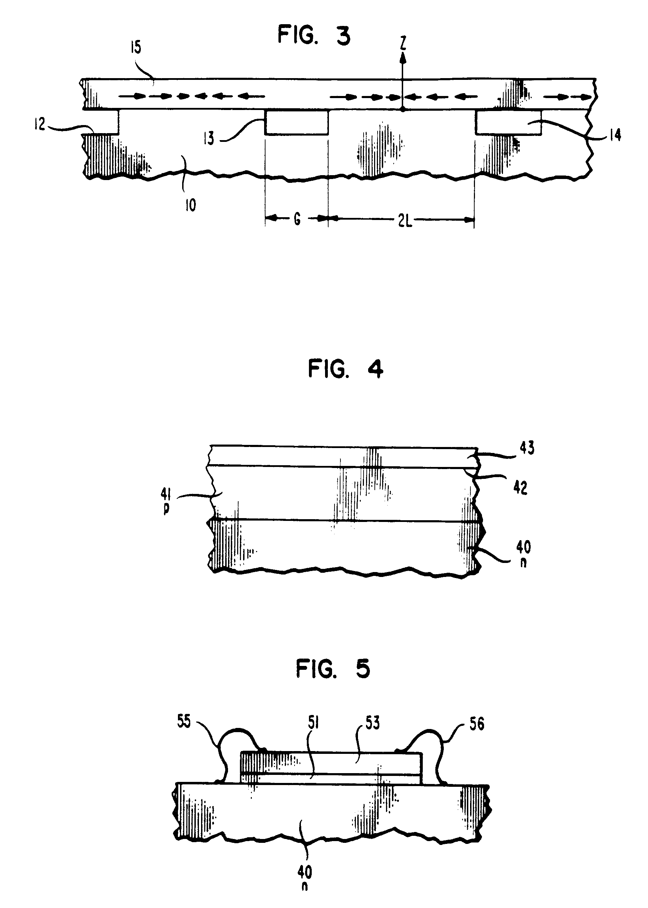

As shown in FIG. 4, an epitaxial germanium layer 43 is located upon the surface 42 of a porous silicon semiconductor substrate portion 41. This porous substrate portion 41 comprises a top p-type portion of a single crystal n-type bulk silicon semiconductor substrate 40 which has been made porous at this top portion, for example, by an anodic reaction with concentrated hydrofluoric acid. The anodic reaction proceeds faster in p-type than in n-type silicon, as known in the art. Such an anodic reaction is described, for example, in a paper authored by M.I.J. Beale et al., entitled "Microstructures and Foundation Mechanism of Porous Silicon" published in Vol. 46, pp. 86-88 (January 1986). Ethanol can advantageously be added to the hydrofluoric acid to suppress the foundation of undesirable bubbles during the anodic reaction. The germanium layer 43 is advantageously grown by molecular beam epitaxy (MBE) upon the surface of the porous substrate after the latter has been suitably cleaned. For example, to clean the surface, the entire substrate is heated in dry oxygen to a temperature of about 300 degrees C, to oxidize a surface portion of the porous silicon; and then the substrate is heated in a vacuum chamber to a temperature of about 700 to 750 degrees C, to remove the oxide. Alternatively, the surface can be cleaned by oxidizing with a solution of hydrogen peroxide and hydrochloric acid followed by the heating in the vacuum chamber. Finally, preferably in the same vacuum chamber, the surface of the substrate is subjected to germanium MBE, as known in the art and described in more detail, for example, in a paper authored by J. C. Bean, entitled "Molecular Beam Epitaxy of $Ge_x$ $Si_{l-x/}$ (Si, Ge) Strained-layer Heterostructures and Superlattices" published in Materials Research Society Symposia Proceedings, Vol. 37, pp. 245-254 (1985).

The epitaxial layer 43 and the porous silicon layer 41 can then be patterned into relatively large area(s) as indicated in FIG. 5, whereby portions of the silicon substrate 40 are exposed. Then, one or more opto-electronic elements or devices can be fabricated in the remaining epitaxial layer 53, with very large scale integrated (VLSI) circuitry being fabricated and integrated in the exposed portions of the silicon substrate 40 as known in the art. These opto-electronic devices and the integrated circuitry can then be electrically interconnected, illustratively, by metallization lines 55 and 56. Typically these lines take the form of aluminum or other suitable metal lines that are insulated from the substrate 40 and from the epitaxial layer 53 by insulating layers (not shown) except at contact areas of the respective devices and circuits through windows in the insulating layers as known in the art. Alternatively, the epitaxial layer could be originally grown upon only a limited portion of the surface of the substrate. Also, instead of, or in addition to, having opto-electronic devices fabricated in the epitaxial layer 53, electronic circuitry can be fabricated in this epitaxial layer, whereby during operation in data processing systems, the circuitry in the epitaxial layer is allocated the task of performing the more critical data calculations, i.e., the calculations that are desirably to be performed with greater speed.

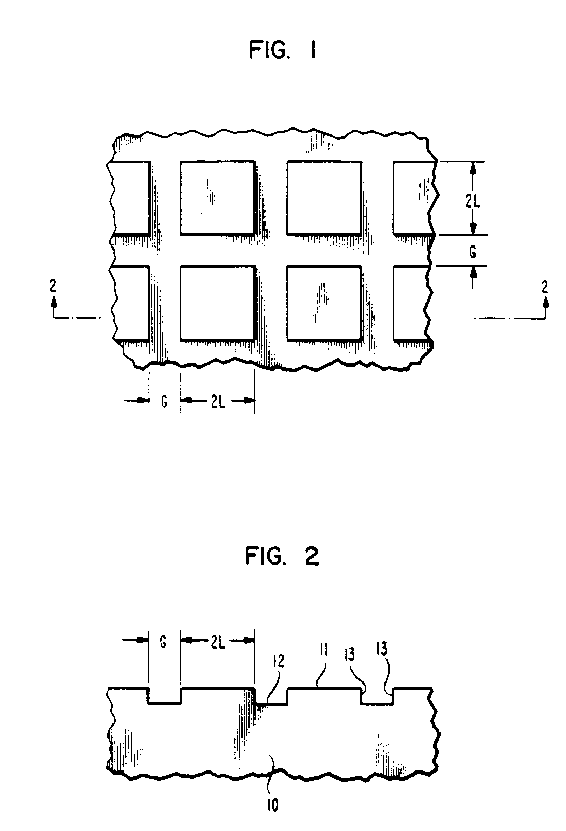

To understand better the underlying principles of the invention, it is useful to turn to FIG. 1, 2 and 3. Here, upon a single crystal substrate 10 having a castellated surface, an epitaxial layer 15 (FIG. 3) has been grown, with tangential stress (caused by lattice mismatch) in the layer at its interface with the substrate indicated by the arrows in FIG. 3. The castellated surface is characterized by flat plateaus 11 (FIG. 2), each of lateral extent 2L, and valleys 12, each of the valleys having vertical sidewalls 13. The valleys 12 have bottom surfaces 12 of lateral extent G. Note that the lengths of the arrows are relatively long at the edges of the plateaus in the immediate vicinity of the valleys and are relatively short near the midpoints of the plateaus, indicating relatively large tangential stress at the edge of the plateaus near the valleys and relatively small stress near the center of the plateaus.

The lateral extent G of the gaps, in accordance with one of the criteria of the invention, should be sufficiently large so that the strain fields that propagate through the epitaxial layer 15 from the strain sources on different plateaus do not interfere, i.e., superposition of strain fields stemming from separate strain sources is not substantial. Consequently, the physical solution to the resulting boundary value problem involving the establishing of strain throughout the epitaxial layer is characterized by exponentially decreasing values of strain as a function of distance from the interface. Thus, the strain energy per unit area of the epitaxial layer will be finite for any arbitrary thickness, no matter how large. Moreover the strain, energy decreases with decreasing lateral extent 2L of the plateaus so that for sufficiently small maximum lateral extent 2L of the plateaus, the strain energy will never exceed the threshold energy for the formation of dislocations. In particular, if 2L of plateaus on a surface of Si is less than about 20nm (200 Angstrom), then the pure Ge epitaxial layers will not have any dislocations regardless of how thick the layer may be. If the lateral extent 2L of the plateaus of Si is somewhat larger, then the pure Ge epitaxial layer will still be dislocation-free provided that its thickness is not too great. In such a case, the critical layer thickness for dislocation-free growth of pure Ge upon Si would be finite but greater than that (1nm (10 Angstrom)) predicted for growth upon unpatterned (smooth) Si.

Various modifications are possible. For example, instead of pure Ge, the dislocation-free epitaxial layer can be about $Ge_xSi_{l-x}$, with concomitant somewhat larger allowed values of lateral plateau extent 2L depending upon x, or it can be gallium arsenide. More generally, the substrate and epitaxial layers can be any lattice-mismatched crystals, semiconductors or non-semiconductors. For example, within the scope of the invention are binary, ternary, or quaternary III-V compound semiconductor alloys--generally, (In, Ga, Al)-(As, P)--grown epitaxially upon lattice-mismatched submicron-patterned III-V single crystal substrates--such as GaAs, InP, or GaP. Note that GaP is only 0.4% lattice mismatched to Si and hence is more nearly perfectly lattice-matched to Si than are other III-V compound semiconductors, but by itself GaP has an indirect gap and is not as useful for optical devices. Thus, also within the scope of the invention is the growth of any III-V lattice-mismatched (with respect to GaP) material upon, for example, a submicron patterned GaP layer which, in turn, has been epitaxially grown upon a smooth (unpatterned) surface of a silicon substrate.

## Claims

1. A semiconductor device comprising an epitaxial layer (15) located upon a surface of a single crystal silicon body (10), the epitaxial layer (15) having a lattice constant different from that of the body (10),
CHARACTERIZED IN THAT
said surface of said silicon body (10) is composed of flat plateaus (11), each plateau having a maximum lateral extent of less than 1 $\mu$m, with gaps formed by grooves (12) located between the plateaus (11).

2. The device of claim 1 in which the epitaxial layer (15) is essentially germanium.

3. The device of claim 2 in which the patterned surface is characterized by plateaus (11) having maximum lateral extents of less than about 20nm and the epitaxial layer (15) has a thickness of at least about 10nm.

4. The device of claim 3 in which neighboring plateaus (11) are separated by gaps of at least about 6nm.

5. The device of claim 1 in which said silicon body surface is porous.

6. The device of claim 5 in which the porous silicon is characterized by plateaus (11) lateral extents of less than 10nm.

7. The device of claim 1 in which the epitaxial layer (15) is essentially gallium arsenide.

8. The device of claim 7 in which the patterned surface is characterized by plateaus (11) maximum lateral extents of less than about 10nm.

9. The device of claim 8 in which neighboring plateaus (11) are separated by gaps of at least 3nm.

10. The device of claim 1 in which said silicon body surface is characterized by plateaus (11) separated by gaps of at least about one-third the maximum lateral extents of the plateaus (11).

## Revendications

1. Un dispositif à semiconducteurs comprenant une couche épitaxiale (15) se trouvant sur une surface d'un bloc de silicium monocristallin (10), la couche épitaxiale (15) ayant une constante de réseau différente de celle du bloc de silicium (10),

CARACTERISE EN CE QUE

la surface du bloc de silicium (10) est constituée par des plateaux (11) de forme plane, chaque plateau ayant une étendue latérale maximale inférieure à 1 $\mu$m, avec des espaces formés par des sillons (12) entre les plateaux (11).

2. Le dispositif de la revendication 1, dans lequel la couche épitaxiale (15) est esentiellement en germanium.

3. Le dispositif de la revendication 2, dans lequel la surface portant un motif est caractérisée par des plateaux (11) ayant des étendues latérales maximales inférieures à environ 20 nm, et la couche épitaxiale (15) a une épaisseur d'au moins environ 10 nm.

4. Le dispositif de la revendication 3, dans lequel des plateaux voisins (11) sont séparés par des espaces d'au moins environ 6 nm.

5. Le dispositif de la revendication 1, dans lequel la surface du bloc de silicium est poreuse.

6. Le dispositif de la revendication 5, dans lequel le silicium poreux est caractérisé par des plateaux (11) ayant des étendues latérales inférieures à 10 nm.

7. Le dispositif de la revendication 1, dans lequel la couche épitaxiale (15) consiste essentiellement en arséniure de gallium.

8. Le dispositif de la revendication 7, dans lequel la surface portant un motif est caractérisée par des plateaux (11) ayant des étendues latérales maximales inférieures à environ 10 nm.

9. Le dispositif de la revendication 8, dans lequel des plateaux voisins (11) sont séparés par des espaces d'au moins 3 nm.

10. Le dispositif de la revendication 1, dans lequel la surface du bloc de silicium est caractérisée par des plateaux (11) séparés par des espaces au moins égaux au tiers environ des étendues latérales maximales des plateaux (11).

**Patentansprüche**

1. Halbleiterbauteil mit einer epitaxialen Schicht (15), die sich auf einer Oberfläche eines Einkristall-Siliziumkörpers (10) befindet und eine Gitterkonstante besitzt, die von der des Körpers (10) verschieden ist,

dadurch gekennzeichnet, daß die Oberfläche des Siliziumkörpers (10) aus flachen Plateaus (11) zusammengesetzt ist, daß jedes Plateau eine maximale Breitenabmessung von weniger als 1 $\mu$m hat und daß durch Rinnen (12) gebildete Lücken zwischen den Plateaus (11) angeordnet ist.

2. Bauteil nach Anspruch 1, bei dem die epitaxiale Schicht (15) im wesentlichen Germanium ist.

3. Bauteil nach Anspruch 2, bei dem die mit einem Muster versehene Oberfläche gekennzeichnet ist durch Plateaus (11), die eine maximale Breitenabmessung von weniger als etwa 20 nm besitzen und wobei die expitaxiale Schicht (15) eine Dicke von wenigstens etwa 10 nm hat.

4. Bauteil nach Anspruch 3, bei dem benachbarte Plateaus (11) durch Lükken von wenigstens etwa 6 nm getrennt sind.

5. Bauteil nach Anspruch 1, bei dem die Oberfläche des Siliziumkörpers porös ist.

6. Bauteil nach Anspruch 5, bei dem das poröse Silizium gekennzeichnet ist durch Plateaus (11) mit einer Seitenabmessung von weniger als 10 nm.

7. Bauteil nach Anspruch 1, bei dem die epitaxiale Schicht (15) im wesentlichen Galliumarsenid ist.

8. Bauteil nach Anspruch 7, bei dem die mit einem Muster versehene Oberfläche gekennzeichnet ist durch Plateaus (11) mit einer maximalen Seitenabmessung von weniger als etwa 10 nm.

9. Bauteil nach Anspruch 8, bei dem benachbarte Plateaus (11) durch Lükken von wenigstens 3 nm getrennt sind.

10. Bauteil nach Anspruch 1, bei dem die Oberfläche des Siliziumkörpers gekennzeichnet ist durch Plateaus (11), die durch Lücken von wenigstens etwa einem Drittel der maximalen Seitenabmessung der Plateaus (11) getrennt sind.

FIG. 1

FIG. 2

## FIG. 3

## FIG. 4

## FIG. 5